(19) Europäisches Patentamt
European Patent Office
Office européen des brevets

(11) **EP 1 532 490 B1**

(12) **EUROPÄISCHE PATENTSCHRIFT**

(45) Veröffentlichungstag und Bekanntmachung des Hinweises auf die Patenterteilung:
**04.04.2012 Patentblatt 2012/14**

(21) Anmeldenummer: 03794908.8

(22) Anmeldetag: **21.08.2003**

(51) Int Cl.:
*G03F 7/20* *(2006.01)*     *G02B 17/08* *(2006.01)*
*G02B 5/08* *(2006.01)*

(86) Internationale Anmeldenummer:
**PCT/EP2003/009253**

(87) Internationale Veröffentlichungsnummer:
**WO 2004/025370 (25.03.2004 Gazette 2004/13)**

(54) **OPTISCHES ABBILDUNGSSYSTEM, INSBESONDERE KATADIOPTRISCHES REDUKTIONSOBJEKTIV**

OPTICAL REPRODUCTION SYSTEM, IN PARTICULAR CATADIOPTRIC REDUCTION LENS

SYSTEME DE REPRODUCTION OPTIQUE, EN PARTICULIER OBJECTIF DE PROJECTION CATADIOPTRIQUE

(84) Benannte Vertragsstaaten:
**DE NL**

(30) Priorität: **27.08.2002 DE 10240598**

(43) Veröffentlichungstag der Anmeldung:
**25.05.2005 Patentblatt 2005/21**

(73) Patentinhaber: **Carl Zeiss SMT GmbH
73447 Oberkochen (DE)**

(72) Erfinder:
• **ZACZEK, Christoph
73540 Heubach (DE)**
• **Kürz, Birgit
73430 Aalen (DE)**
• **ULLMANN, Jens
73447 Oberkochen (DE)**
• **WAGNER, Christian
NL-5521 KS Eersel (NL)**

(74) Vertreter: **Patentanwälte
Ruff, Wilhelm, Beier, Dauster & Partner
Postfach 10 40 36
70035 Stuttgart (DE)**

(56) Entgegenhaltungen:
**EP-A- 0 964 282     EP-A- 1 001 295
EP-A- 1 130 470     DE-A- 10 126 364
US-A- 4 322 130     US-A- 5 850 309**

**Beschreibung**

Die Erfindung betrifft ein katadioptrisches Projektionsobjektiv zur Abbildung eines in einer Objektebene des Projektionsobjektivs angeordneten Musters in die Bildebene des Projektionsobjektivs.

Katadioptrische Projektionsobjektive werden in Projektionsbelichtungsanlagen zur Herstellung von Halbleiterbauelementen und anderen feinstrukturierten Bauteilen verwendet, insbesondere in Waferscannern und Wafersteppern. Sie dienen dazu, Muster von Photomasken oder Strichplatten, die nachfolgend auch als Masken oder Retikel bezeichnet werden, auf einen mit einer lichtempfindlichen Schicht beschichteten Gegenstand mit höchster Auflösung in verkleinerndem Maßstab zu projizieren.

Zur Erzeugung immer feinerer Strukturen wird angestrebt, einerseits die bildseitige numerische Apertur (NA) der Projektionsobjektive zu vergrößern und andererseits immer kürzere Wellenlängern zu verwenden, vorzugsweise Ultraviolettlicht mit Wellenlängen von weniger als ca. 260 nm.

In diesem Wellenlängenbereich stehen nur noch wenig ausreichend transparente Materialien zur Herstellung der optischen Komponenten zur Verfügung, insbesondere synthetisches Quarzglas und Fluoridkristalle, wie Kalziumfluorid. Da die Abbekonstanten der verfügbaren Materialien relativ nahe beieinander liegen, ist es schwierig, rein refraktive Systeme mit ausreichender Korrektur von Farbfehlern (chromatische Aberration) bereitzustellen. Daher werden für höchstauflösende Projektionsobjektive überwiegend katadioptrische System verwendet, bei denen brechende und reflektierende Komponenten, insbesondere also Linsen und Siegel, kombiniert sind.

Bei der Nutzung von abbildenden Spiegelflächen ist es erforderlich, Strahlumlenkeinrichtungen einzusetzen, wenn eine obskurationsfreie und vignettierungsfreie Abbildung erreicht werden soll. Neben Systemen mit physikalischem Strahlteiler, insbesondere mit polarisationsselektiv wirksamer Spiegelfläche, sind Systeme mit geometrischer Strahlteilung mittels einem oder mehreren, voll reflektierenden Umlenkspiegeln bekannt. Systeme dieser Art haben einen ersten Umlenkspiegel, der gegenüber der optischen Achse gekippt ist und dazu dient, entweder die von der Objektebene kommende Strahlung zum Konkavspiegel umzulenken oder dazu, die vom Konkavspiegel reflektierte Strahlung zu nachfolgenden Objektivteilen umzulenken. In der Regel ist ein zweiter Umlenkspiegel vorgesehen, der als Faltungsspiegel dient, um Objektebene und Bildebene zu parallelisieren. Um eine hohe Reflektivität dieser Spiegel zu gewährleisten, sind sie üblicherweise mit einer Reflexschichtung, meist dielektrischen Mehrfachschichten oder einer Kombination aus metallischen und dielektrischen Schichten, belegt. Durch dielektrische Schichten, die unter hohem Einfallswinkel betrieben werden, kann das durchtretende Licht polarisationsabhängig beeinflusst werden.

Es ist beobachtet worden, dass bei solchen katadioptrischen Systemen unter gewissen Abbildungsbedingungen verschiedene im abzubildenden Muster enthaltene Strukturrichtungen mit unterschiedlichem Kontrast abgebildet werden. Diese Kontrastunterschiede für verschiedene Strukturrichtungen werden auch als H-V-Differenzen (Horizontal-Vertikal-Differenzen) oder als Variationen der kritischen Dimensionen (CD-Variationen) bezeichnet und machen sich im Photoresist als unterschiedliche Linienbreiten für die verschiedenen Strukturrichtungen bemerkbar.

Es sind verschiedene Vorschläge zur Vermeidung solcher richtungsabhängiger Kontrastunterschiede gemacht worden. Die EP 964 282 A2 beschäftigt sich mit dem Problem, dass bei katadioptrischen Projektionssystemen mit Umlenkspiegeln beim durchtretenden Licht eine Polarisationsvorzugsrichtung eingeführt wird, die sich dadurch ergibt, dass bei den mehrfach beschichteten Umlenkspiegeln der Reflexionsgrad für s-polarisiertes Licht jeweils höher ist als für p-polarisiertes Licht. Dadurch wird Licht, welches in der Retikelebene noch unpolarisiert ist, in der Bildebene teilweise polarisiert, was zu einer Richtungsabhängigkeit der Abbildungseigenschaften führen soll. Diesem Effekt wird dadurch entgegengewirkt, dass im Beleuchtungssystem durch Erzeugung von teilweise polarisiertem Licht mit vorgegebenem Restpolarisationsgrad ein Vorhalt an Polarisation geschaffen wird, der durch die Projektionsoptik so kompensiert wird, dass an deren Ausgang unpolarisiertes Licht austritt.

Die DE 198 51 749 (entsprechend EP 1 001 295) zeigt ein katadioptrisches Projektionsobjektiv mit einem geometrischen Strahlteiler mit zwei senkrecht aufeinander stehenden Umlenkspiegeln. Polarisationsabhängige Effekte hinsichtlich Strahlgeometrie und Phase, wie sie durch die Unterschiede der Reflexion in Abhängigkeit von der Polarisationsrichtung bezogen auf die Reflexionsebene entstehen können, werden bei einer Ausführungsform durch zusätzliche Umlenkungen an einem Umlenkspiegel kompensiert, bei dem die Einfallsebene nicht komplanar mit der Einfallsebene an den Umlenkspiegeln des Strahlteilers, sondern senkrecht zu dieser ausgerichtet ist. Bei einer anderen Ausführungsform tragen die Umlenkspiegel der Strahlumlenkeinrichtung phasenkorrigierende, dielektrische dünne Schichten, die eine Kompensation polarisationsspezifischer Effekte bei der Reflexion an dem Umlenkspiegel bewirken sollen. Es werden keine Details zum Aufbau dieser Schichten angegeben.

Das Patent US 4,322,130 offenbart phasenverschiebende Spiegel (phase shifting mirrors). Ein solcher Spiegel hat ein Substrat, auf dem eine dünne Metallschicht aufgebracht ist. Auf der dünnen Metallschicht ist eine dünne Schicht aus dielektrischem Material aufgebracht. Eine Phasendifferenz zwischen einer p-polarisierten reflektierten Komponente und einer s-polarisierten reflektierten Komponente von der Reflexion an der Grenzfläche zwischen der Metallschicht der dielektrischen Schicht und Variationen im Brechungsindex und Schichtdicke des dielektrischen Schichtmaterials werden genutzt, um eine gewünschte Phasendifferenz zwischen s- und p-polarisierten reflektierten Komponenten zu erreichen.

Der Erfindung liegt die Aufgabe zugrunde, ein katadioptrisches Projektionsobjektiv mit mindestens zwei gegenüber der optischen Achse gekippten Umlenkspiegeln bereitzustellen, bei dem eine polarisationsabhängige Beeinflussung des durchtretenden Lichtes durch die Umlenkspiegel vermindert oder vermieden wird. Insbesondere soll ein katadioptrisches Projektionsobjektiv mit geometrischem Strahlteiler bereitgestellt werden, welches für verschiedene Strukturrichtungen eines Musters eine Abbildung im wesentlichen ohne strukturrichtungsabhängige Kontrastunterschiede erlaubt.

Diese Aufgabe wird durch ein katadioptrisches Projektionsobjektiv mit den Merkmalen von Anspruch 1 gelöst. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Ein optisches Abbildungssystem, das zur Abbildung eines in der Objektebene des Abbildungssystems angeordneten Musters in die Bildebene des Abbildungssystems dient und als katadioptrisches Projektionsobjektiv ausgestaltet ist, hat eine optische Achse, einen ersten Umlenkspiegel, der gegenüber der optischen Achse um einen ersten Kippwinkel gekippt ist und einen zweiten Umlenkspiegel, der gegenüber der optischen Achse um einen zweiten Kippwinkel gekippt ist. Die Umlenkspiegel sind um parallele Kippachsen gegenüber der optischen Achse des Systems verkippt und so angeordnet, dass Objektebene und Bildebene parallel ausgerichtet sind. Die Umlenkspiegel sind so ausgestaltet, dass ein Verhältnis $R_{sp}$ zwischen dem Reflexionsgrad $R_s$ eines Umlenkspiegels für s-polarisiertes Licht und dem Reflexionsgrad $R_p$ des Umlenkspiegels für p-polarisiertes Licht aus einem den zugeordneten Kippwinkel umfassenden Inzidenzwinkelbereich bei einem der Umlenkspiegel größer als eins und bei dem anderen Umlenkspiegel kleiner als eins ist.

Die Kippwinkel der Umlenkspiegel sind hier als Winkel zwischen der optischen Achse am Umlenkspiegel und der Flächennormalen der ebenen Spiegelfläche definiert. Der Inzidenzwinkel wird auch als Einfallswinkel bezeichnet und ist definiert als Winkel zwischen der Einfallsrichtung von Licht auf den Umlenkspiegel und der Flächennormalen. Bei parallel zur optischen Achse einfallendem Licht entspricht somit der Inzidenzwinkel dem Kippwinkel des Umlenkspiegels. Bei Licht mit s-Polarisation schwingt der elektrische Feldvektor senkrecht zur Einfallsebene, die von der Einstrahlrichtung und der Flächennormalen des Umlenkspiegels aufgespannt wird, bei p-polarisiertem Licht schwingt der elektrische Feldvektor parallel zu dieser Einfallsebene.

Die Reflexionsgrade der Spiegel für die unterschiedlichen Polarisationsrichtungen sind somit derart ausgelegt, dass einer der beiden Umlenkspiegel die s-Polarisation im relevanten Inzidenzwinkelbereich um den Kippwinkel stärker reflektiert als die p-Polarisation und dass beim anderen Umlenkspiegel ein umgekehrtes Verhältnis der Reflexionsgrade vorliegt. Dadurch ist es möglich, eine durch den ersten Umlenkspiegel verursachte Veränderung im Verhältnis der reflektierten Intensitäten für s-und p-Polarisation mit Hilfe der Reflexion am zweiten Umlenkspiegel zumindest teilweise zu kompensieren. Dadurch kann beispielsweise erreicht werden, dass bei Verwendung von zirkularpolarisiertem oder unpolarisiertem Eingangslicht der Polarisationszustand des Lichtes nach zweifacher Reflexion an den Umlenkspiegeln zumindest wieder annähernd zirkularpolarisiert oder unpolarisiert ist, ohne dass sich durch die doppelte Reflexion an den Umlenkspiegel eine substantielle Bevorzugung einer der Polarisationsrichtungen einstellt.

Bekanntlich ist es so, dass bei Verwendung herkömmlicher Mehrlagenbeschichtungen an Umlenkspiegeln der Reflexionsgrad für s-Polarisation über den gesamten Winkelbereich größer ist als für p-Polarisation, wobei sich besonders im Bereich des bei ca. 54° bis ca. 60° liegenden Brewster-Winkels starke Reflektivitätsunterschiede ergeben können. Somit würde bei Verwendung herkömmlicher Spiegeltechnologie auf beiden Umlenkspiegeln die p-Komponente des elektrischen Feldes stärker geschwächt als die s-Komponente, was zu den genannten strukturrichtungsabhängigen Auflösungsdifferenzen beitragen kann. Dadurch, dass bei erfindungsgemäßen Projektionsobjektiven einer der Umlenkspiegel im relevanten Inzidenzwinkelbereich p-Polarisation stärker reflektiert als s-Polarisation, ist demgegenüber eine teilweise oder vollständige Kompensation von Reflektivitätsunterschieden durch die Umlenkspiegel möglich.

Die Erfindung ist bei katadioptrischen Projektionsobjektiven mit geometrischem Strahlteiler einsetzbar. Bei solchen Projektionsobjektiven ist zwischen Objektebene und Bildebene ein katadioptrischer Objektivteil mit einem Konkavspiegel und einem ersten Umlenkspiegel angeordnet, der zur Umlenkung der von der Objektebene kommenden Strahlung zum Konkavspiegel oder zur Umlenkung der von dem Konkavspiegel kommenden Strahlung zur Bildebene vorgesehen ist. Ein zweiter, nicht funktionsnotweniger Umlenkspiegel dient dann zur Parallelisierung von Objektebene und Bildebene. Bei typischen Ausführungsformen liegen der erste und der zweite Kippwinkel im Bereich von 45° ± 15°, insbesondere von 45° ± 10°. Diese bevorzugten Kippwinkelbereiche bedingen, dass auch die Inzidenzwinkel der einfallenden Strahlung ihren Schwerpunkt um 45° ± 15° haben, also in der Nähe oder mindestens teilweise im Bereich üblicher Brewster-Winkel, in deren Bereich die Unterschiede zwischen den Reflexionsgraden für s- und p-Polarisation besonders groß sind. Hier ist somit die Erfindung besonders nützlich, um diese Unterschiede auszugleichen.

Für den Umlenkspiegel mit $R_{sp} > 1$ kann jede für den relevanten Wellenlängenbereich geeignete Ausführung gewählt werden, beispielsweise ein herkömmlicher Spiegel mit reflektierender Metallschicht und einer darauf angeordneten dielektrischen Beschichtung mit einer oder mehreren dielektrischen Schichten, die der Reflexionsverstärkung dienen kann. Der andere Umlenkspiegel, der im relevanten Inzidenzwinkelbereich für p-Polarisation stärker reflektierend wirken soll ($R_{sp} < 1$), hat eine Reflexbeschichtung mit einer Metallschicht und einer auf der Metallschicht angeordnete dielektrische Schicht. Dabei ist die (geometrische) Schichtdicke $d_f$ der dielektrischen Schicht so gewählt, dass das Verhältnis $R_{sp}$ in einem den zugeordneten Kippwinkel des Umlenkspiegels umfassenden Inzidenzwinkelbereich kleiner als eins ist.

Die Verwendung einer für das verwendete Licht reflektierenden Metallschicht ist sehr vorteilhaft, um eine starke Reflexionswirkung des Umlenkspiegels über einen großen Winkelbereich zu erzielen. Insbesondere für Anwendungen bei Wellenlängen von 260nm oder darunter ist es günstig, wenn die Metallschicht im wesentlichen aus Aluminium besteht. Dieses Material verbindet relative hohe Reflektivitäten mit ausreichender Beständigkeit gegen die energiereiche Strahlung. Auch andere Metalle, beispielsweise Magnesium, Iridium, Zinn, Beryllium oder Ruthenium sind möglich. Es hat sich gezeigt, dass es bei Verwendung von Metalischichten möglich ist, einfach aufgebaute Reflexbeschichtungen zu erhalten, die über einen großen Winkelbereich die p-Polarisationskomponente stärker als die s-Polarisationskomponente reflektieren. Entscheidend ist hierbei die richtige geometrische Schichtdicke $d_f$ des dielektrischen Materials. Generell wird beobachtet, dass für eine gegebene Materialkombination aus Metallschicht und dielektrischer Schicht die Reflexionsgrade für p-Polarisation und s-Polarisation als Funktion der Schichtdicke $d_f$ etwa periodisch und mit teilweise gegenläufiger Tendenz und/oder unterschiedlicher Amplitude variieren, wobei sich gewisse Schichtdickenbereiche dadurch auszeichnen, dass in ihnen der Reflexionsgrad $R_p$ für p-Polarisation größer ist der Reflexionsgrad $R_s$ für s-Polarisation.

Es können praktisch absorptionsfreie oder auch leicht absorbierende dielektrische Materialien verwendet werden. Bei der Auswahl leicht absorbierender Materialien ist darauf zu achten, dass sie das Licht der Arbeitswellenlängen nur wenig absorbieren, um den Wirkungsgrad der Spiegel nicht durch Absorption spürbar zu verschlechtern. Bei geeigneten Materialien kann der Absorptionskoeffizient $k_d$ des dielektrischen Materials im Bereich $k_d \leq 0{,}6$, insbesondere im Bereich $k_d \leq 0{,}01$ liegen. Materialien mit $k_d \leq 10^{-6}$ werden hier als praktisch absorptionsfrei bezeichnet. Der Absorptionskoeffizient $k$ eines Materials ist in dieser Anmeldung als Imaginärteil der komplexen Brechzahl $N = n - ik$ definiert, wobei $N$ die komplexe Brechzahl, $n$ der Realteil der Brechzahl und $k$ der Imaginärteil der komplexen Brechzahl ist. Der dimensionslose Absorptionskoeffizient $k$, der gelegentlich auch als Extinktionskoeffizient bezeichnet wird, hängt mit dem dimensionsbehaftet Absorptionskoeffizienten $\alpha$[1/cm] über die Beziehung $k = (\alpha\lambda)/4\pi$ zusammen, wobei $\lambda$ die entsprechende Wellenlänge des Lichtes repräsentiert.

Für Arbeitswellenlängen von 157nm kann die dielektrische Schicht beispielsweise im wesentlichen aus einem der folgenden Materialien oder aus einer Kombination dieser Materialien bestehen: Magnesiumfluorid ($MgF_2$), Aluminiumfluorid ($AlF_3$), Chiolith, Kryolith, Gadoliniumfluorid ($GdF_3$), Siliziumdioxid ($SiO_2$), Lanthanfluorid ($LaF_3$) oder Erbiumfluorid ($ErF_3$). Für 193nm sind alle diese Materialien geeignet, ausserdem z.B. noch Aluminiumoxid ($Al_2O_3$). Bei 248nm sind alle für 157nm oder 193nm genannten Schichtmaterialien geeignet, ausserdem kann z.B. noch Hafniumoxid ($HfO_2$) verwendet werden.

Die Auswahl der richtigen Schichtdicke $d_f$ der dielektrischen Schicht für ein gegebenes Schichtmaterial, die vorgegebene Wellenlänge und einen gewünschten Inzidenzwinkelbereich kann experimentell durchgeführt werden. Besonders geeignet sind Schichtdicken, bei denen folgende Bedingung erfüllt ist:

$$0.3 \leq \frac{\sin\left(\phi_f\left(d_f, \alpha_0\right)\right)}{N_f \cdot \cos\left(\phi_f\left(d_f, \alpha_0\right)\right)} \leq 1.5 \qquad (1)$$

wobei $\Phi_f$ die Phasendicke der dielektrischen Schicht als Funktion der Schichtdicke $d_f$ und des Inzidenzwinkels $\alpha_0$ und $N_f$ die komplexe Brechzahl des dielektrischen Materials ist. Dabei ergibt sich beispielsweise, dass bei niedrigberechenden Materialien der Wert des Bruches in Gl. (1) bevorzugt im Bereich von ca. 1 bis ca. 1.5 liegt, während er bei hochbrechenden dielektrischen Materialien bevorzugt im Bereich von ca. 0.3 bis ca. 1 liegt. Zähler und Nenner der Funktion in Gleichung (1) können z.B. etwa gleich sein. Um diesen Punkt herum gibt es abhängig vom betrachteten Inzidenzwinkel mehr oder weniger breite Schichtdickenbereiche mit $R_{sp} < 1$, wobei sich gezeigt hat, dass tendenziell die Breite der Schichtdickenbereiche und der Unterschied zwischen den Reflexionsgraden für s- und p-Polarisation mit wachsendem Inzidenzwinkel zunimmt.

Besonders günstige Schichtdicken liegen im Bereich des ersten Schnittpunktes der oben genannten, von den Phasendicken abhängigen Kurven, da in diesem Fall der Inzidenzwinkelbereich, in dem $R_{sp} < 1$ ist, besonders breit wird. Damit sind häufig relativ dünne dielektrische Schichten, beispielsweise mit $d_f \leq 35$nm oder $d_f \leq 30$nm günstig. Auch Schichtdicken aus dem Bereich von Schnittpunkten höherer Ordnungen sind möglich und können beispielsweise dann genutzt werden, wenn nur Licht aus einem kleinen Einfallswinkelbereich auf einen solchen Spiegel fällt.

Beschrieben wird auch ein Spiegel, insbesondere ein Spiegel für Ultraviolettlicht aus einem Wellenlängenbereich von unterhalb von 260nm, mit einem Spiegelsubstrat und einer auf dem Substrat angeordneten Reflexbeschichtung, die eine Metallschicht und eine auf der Metallschicht angeordnete dielektrische Schicht aus dielektrischen Material umfasst, deren Schichtdicke $d_f$ so gewählt ist, dass das Verhältnis $R_{sp}$ in dem Inzidenzwinkelbereich, für den der Spiegel vorgesehen ist, kleiner als eins ist. Die Spiegelfläche des Spiegels kann eben sein, beispielsweise wenn der Spiegel als Umlenkspiegel bzw. Faltungsspiegel genutzt werden soll. Auch Spiegel mit gekrümmter Spiegelfläche, d.h. Konvexspiegel oder Konkavspiegel sind möglich.

Die Erfinder haben erkannt, dass sich das Verhältnis $R_{sp}$ der reflexionsgrade für s- und p-Polarisation eines Spiegels durch geeignete Wahl der Schichtdicke $d_f$ einer dielektrischen Schicht aus im wesentlichen absorptionsfreiem oder leicht absorbierendem Material gezielt einstellen lässt. Auf Grundlage dieser Erkenntnis ist es daher auch möglich, Spiegel zu fertigen, bei denen die Reflexionsgrade $R_s$ und $R_p$ zumindest bei einem vorgegebenen Inzidenzwinkel oder einem engeren oder breiteren Inzidenzwinkelbereich im wesentlichen gleich sind oder beispielsweise nur um maximal 10% oder 5% voneinander abweichen. Derart polarisationsneutrale Spiegel können für eine Vielzahl von Anwendungen nützlich sein.

Die vorstehenden und weiteren Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei Ausführungsformen der Erfindung und auf anderen Gebieten verwirklicht sein und vorteilhafte sowie für sich schutzfähige Ausführungen darstellen können.

Fig. 1    ist eine schematische Darstellung einer Lithographie-Projektionsbelichtungsanlage, die ein katadioptrisches Projektionsobjektiv mit geometrischem Strahlteiler gemäß einer Ausführungsform der Erfindung umfasst;

Fig. 2    ist ein Diagramm, das schematisch die Abhängigkeit der Reflektivität R eines herkömmlichen Spiegels vom Inzidenzwinkel $\alpha_o$ der einfallenden Strahlung für s- und p-polarisiertes Licht zeigt;

Fig. 3    ist eine schematische Detailansicht des katadioptrischen Objektivteils des in Fig. 1 gezeigten Projektionsobjektivs;

Fig. 4    ist ein Diagramm, welches Messwerte für die Inzidenzwinkelabhängigkeit der Reflexionsgrade $R_p$ und $R_s$ für p- und s-polarisiertes Licht an einem der Umlenkspiegel zeigt, wobei im Inzidenzwinkelbereich ab ca. 20° gilt: $R_p > R_s$;

Fig. 5    ist ein berechnetes Diagramm, das die Abhängigkeit der Reflexionsgrade $R_p$ und $R_s$ als Funktion der Schichtdicke $d_f$ einer Reflexionsschicht zeigt, bei der auf einer Aluminiumschicht eine Einzelschicht aus Siliziumdioxid aufgebracht ist;

Fig. 6    ist eine Diagramm, das berechnete Werte $R_p$ und $R_s$ als Funktion des Inzidenzwinkels für eine Reflexionsschicht zeigt, deren Schichtparameter den Schichtparametern der für Fig. 4 vermessenen Reflexionsschicht entsprechen.

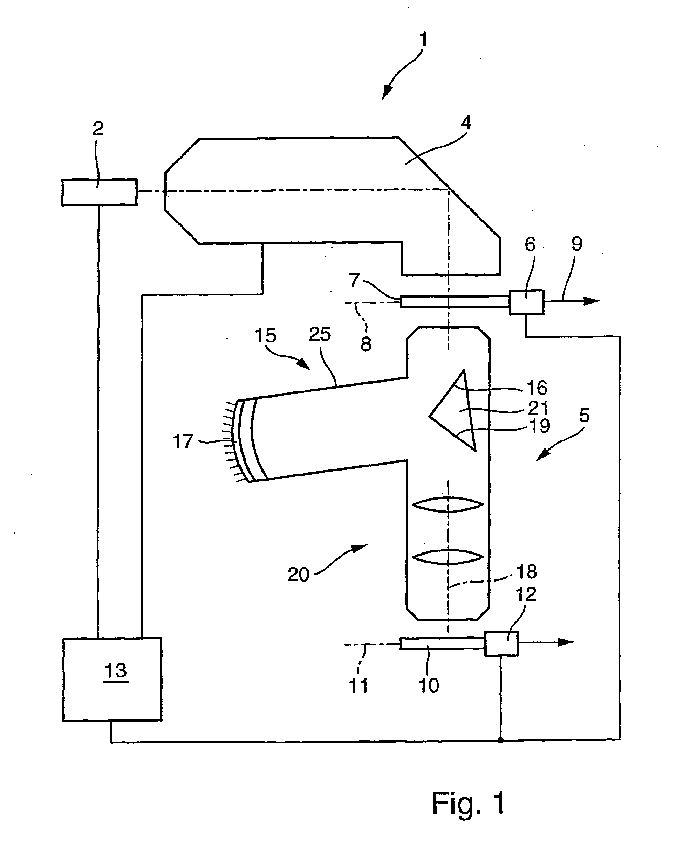

In Fig. 1 ist schematisch eine Mikrolithographie-Projektionsbelichtungsanlage in Form eines Wafer-Steppers 1 gezeigt, der zur Herstellung von hochintegrierten Halbleiterbauelementen vorgesehen ist. Die Projektionsbelichtungsanlage umfasst als Lichtquelle einen Excimer-Laser 2, der Ultraviolettlicht mit einer Arbeitswellenlänge von 157nm ausstrahlt, die bei anderen Ausführungsformen auch darüber, beispielsweise bei 193nm oder 248nm, oder darunter liegen kann. Ein nachgeschaltetes Beleuchtungssystem 4 erzeugt ein großes, scharf begrenztes und homogen beleuchtetes Bildfeld, das an die Telezentrie-Erfordernisse des nachgeschalteten Projektionsobjektivs 5 angepasst ist. Das Beleuchtungssystem hat Einrichtungen zur Auswahl des Beleuchtungsmodus und ist beispielsweise zwischen konventioneller Beleuchtung mit variablen Kohärenzgrad, Ringfeldbeleuchtung und Dipol- oder Quadrupolbeleuchtung umschaltbar. Hinter dem Beleuchtungssystem ist eine Einrichtung 6 zum Halten und Manipulieren einer Maske 7 so angeordnet, dass die Maske in der Objektebene 8 des Projektionsobjektivs liegt und in dieser Ebene zum Scannerbetrieb in einer Abfahrrichtung 9 (y-Richtung) mittels eines Scanantriebs bewegbar ist.

Hinter der Maskenebene 8 folgt das Projektionsobjektiv 5, das als Reduktionsobjektiv wirkt und ein Bild eines an der Maske angeordneten Musters in reduziertem Maßstab, beispielsweise im Maßstab 1: 4 oder 1:5, auf einen mit einer Photoresistschicht bzw. Photolackschicht belegten Wafer 10 abbildet, der in der Bildebene 11 des Reduktionsobjektivs angeordnet ist. Andere Reduktionsmaßstäbe, beispielsweise stärkere Verkleinerungen bis 1 : 20 oder 1 : 200 sind möglich. Der Wafer 10 wird durch eine Einrichtung 12 gehalten, die einen Scannerantrieb umfasst, um den Wafer synchron mit dem Retikel 7 parallel zu diesem zu bewegen. Alle Systeme werden von einer Steuereinheit 13 gesteuert.

Das Projektionsobjektiv 5 arbeitet mit geometrischer Strahlteilung und hat zwischen seiner Objektebene (Maskenebene 8) und seiner Bildebene (Waferebene 11) einen katadioptrischen Objektivteil 15 mit einem ersten Umlenkspiegel 16 und einem Konkavspiegel 17, wobei der ebene Umlenkspiegel 16 derart gegenüber der optischen Achse 18 des Projektionsobjektivs gekippt ist, dass die von der Objektebene kommende Strahlung durch den Umlenkspiegel 16 in Richtung Konkavspiegel 17 umgelenkt wird. Zusätzlich zu diesem für die Funktion des Projektionsobjektivs notwenigen Spiegel 16 ist ein zweiter, ebener Umlenkspiegel 19 vorgesehen, der derart gegenüber der optischen Achse gekippt ist, dass die vom Konkavspiegel 17 reflektierte Strahlung durch den Umlenkspiegel 19 in Richtung Bildebene 11 zu den Linsen des nachfolgenden, dioptrischen Objektivteils 20 umgelenkt wird. Die senkrecht aufeinander stehenden, ebenen Spiegelflächen 16, 19 sind an einer als Spiegelprisma ausgebildeten Strahlumlenkeinrichtung 21 vorgesehen und haben parallele Kippachsen senkrecht zur optischen Achse 18.

Der Konkavspiegel 17 ist in einem schräg gestellten Seitenarm 25 untergebracht. Durch die Schrägstellung des Seitenarms kann unter anderem auf der Maskenseite ein ausreichender Arbeitsabstand über die gesamte Breite des Objektivs sichergestellt werden. Entsprechend können die Kippwinkel der mit ihren Ebenen senkrecht aufeinander stehenden Umlenkspiegel 16, 19 gegenüber der optischen Achse 18 und mehrere Grad von 45° abweichen, beispielsweise um ± 2° bis ± 10°. Bei anderen Ausführungsformen liegen die Kippwinkel der Umlenkspiegel bei 45°.

Im gezeigten Beispiel ist der katadioptrische Objektivteil so ausgelegt, dass im Bereich des zweiten Umlenkspiegels 19 ein Zwischenbild entsteht, welches bevorzugt nicht mit der Spiegelebene zusammenfällt, sondern entweder dahinter oder in Richtung Konkavspiegel 17 davor liegen kann. Es sind auch Ausführungsformen ohne Zwischenbild möglich. Weiterhin ist es möglich, die Spiegel 16, 19 als körperlich von einander getrennte Spiegel auszubilden.

Die Spiegelflächen der Umlenkspiegel 16, 19 sind zur Erzielung hoher Reflexionsgrade mit hochreflektierenden Reflexschichten 23, 24 belegt. Die Reflexionsschicht 23 des ersten Umlenkspiegels kann konventionell aufgebaut sein. Im Beispiels ist auf dem Spiegelsubstrat eine Aluminiumschicht aufgebracht, auf der zur Reflexionsverstärkung ein dielektrisches Mehrschichtsystem aufgebracht ist. Schichten dieses Typs sind an sich bekannt, beispielsweise aus der US 4,856,019, der US 4,714,308 oder der US 5,850,309. Möglich sind auch Reflexionsschichten mit einer Metallschicht, z.B. einer Aluminiumschicht, und einer einzelnen, darauf angebrachten dielektrischen Schutzschicht, beispielsweise aus Magnesiumfluorid. Solche Schichtsysteme sind ebenfalls in den genannten Schriften dargestellt.

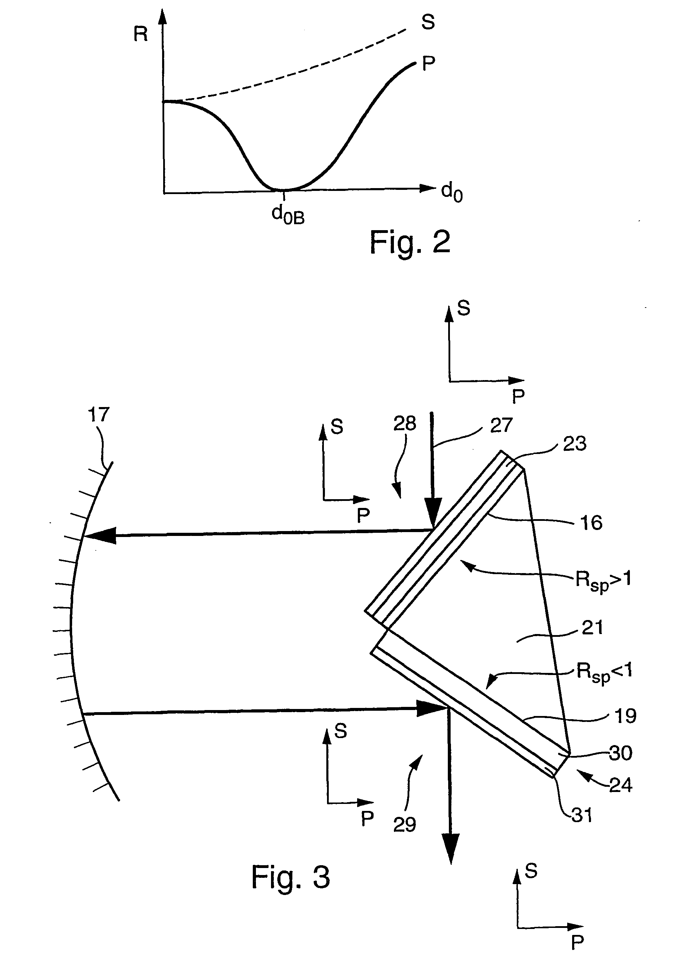

Solche herkömmlichen Schichtsysteme haben bekanntlich unterschiedliche Reflexionsgrade für s- und p-Polarisation. Ein für ein Einfachsystem (Metall/dielektrische Einfachschicht) typischer Verlauf des Reflexionsgrades R als Funktion des Inzidenzwinkels $\alpha_o$ ist schematisch in Fig. 2 gezeigt. Danach ist es so, dass die Reflexionsgrade für s- und p-Polarisation bei senkrechtem Einfall (Inzidenzwinkel 0°) gleich sind. Mit steigendem Inzidenzwinkel nimmt der Reflexionsgrad für s-Polarisation monoton zu, während der Reflexionsgrad für p-Polarisation zunächst aufgrund des Brewster-Winkels abnimmt, um bei weiterer Steigerung des Inzidenzwinkels wieder zuzunehmen. Generell ist somit bei üblichen Reflexionsschichten der Reflexionsgrad für s-Polarisation über den gesamten Winkelbereich größer als für p-Polarisation, wobei sich im Bereich zwischen ca. 45° und ca. 80° besonders starke Reflektivitätsunterschiede ergeben.

Dies kann bei herkömmlichen Projektionsobjektiven mit der beispielhaft gezeigten geometrischen Strahlteilung dazu führen, dass die p-Komponente des elektrischen Feldes beim Durchtritt durch das Objektiv stärker geschwächt wird als die s-Komponente, so dass beispielsweise bei eintrittsseitigem, unpolarisiertem oder zirkularpolarisiertem Licht das in der Bildebene auftreffende Licht eine stärkere s-Komponente aufweist. Dadurch können strukturrichtungsabhängige Auflösungsdifferenzen entstehen.

Diese Probleme werden bei der gezeigten Ausführungsform dadurch vermieden, dass die Reflexionsschicht 24 des zweiten Umlenkspiegels im relevanten Inzidenzwinkelbereich um ca. 45° für p-polarisiertes Licht einen wesentlich höheren Reflexionsgrad hat als für s-Polarisation, so dass das Verhältnis $R_{sp} < 1$ ist.

Zur Erzeugung des Spiegels ist auf dem Spiegelsubstrat, welches aus einem Material mit geringem thermischen Ausdehnungskoeffizienten besteht, eine optische dichte Aluminiumschicht 30 mit ca. 65nm bis 100nm Schichtdicke aufgebracht. Die Aluminiumschicht ist mit einer Einzelschicht 31 aus Siliziumdioxid mit ca. 15nm Schichtdicke belegt. Mit Hilfe dieses Umlenkspiegels ist es möglich, die durch den ersten Umlenkspiegel verursachte Bevorzugung der s-Polarisation teilweise oder ganz zu -kompensieren, indem bei diesem Spiegel die s-Komponente deutlich schwächer reflektierte wird als die p-Komponente des Lichtes.

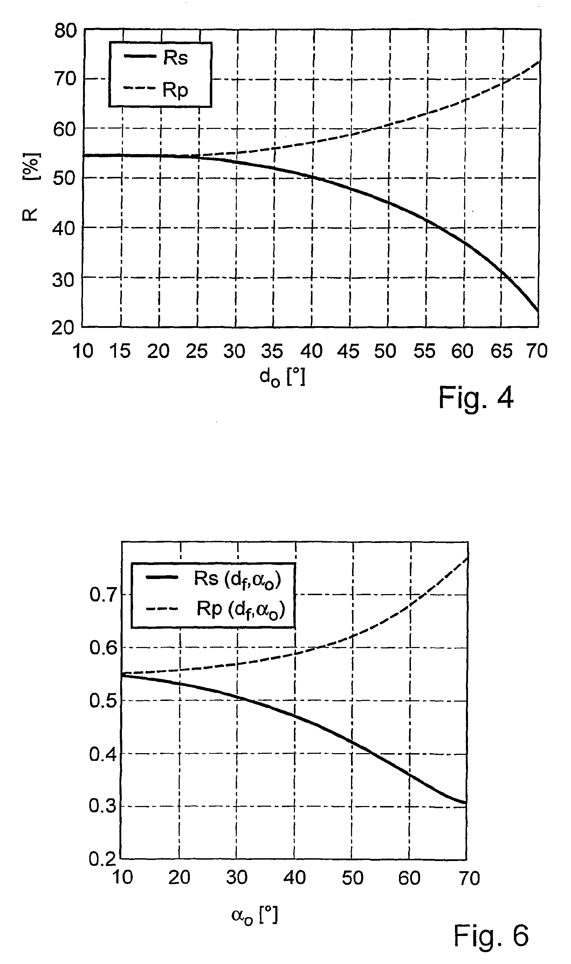

Zur Erläuterung dieses Effekts zeigt Fig. 3 ein Beispiel, bei dem das auf den ersten Umlenkspiegel 16 treffende Eingangslicht 27 zirkular polarisiert ist, wobei die durch die Pfeillängen symbolisierten Amplituden von s- und p-Polarisation im wesentlich gleich sind. Nach Reflexion am schräggestellten Spiegel 16 ist die parallel zur Einfallsebene schwingende Komponente des elektrischen Feldes stärker geschwächt als die s-Komponente. Dieses teilpolarisierte Licht läuft Richtung Konkavspiegel 17. Nach Reflexion am Konkavspiegel 17, bei der der Polarisationszustand weitgehend unverändert bleibt, trifft das reflektierte Licht auf den zweiten Umlenkspiegel 19. An diesem wird nun die p-Komponente aufgrund der anhand von Fig. 4 erläuterten Reflektivitätsunterschiede ($R_p > R_s$) stärker reflektiert als die (stärkere) s-Komponente, so dass sich eine Angleichung der Amplituden für s- und p-Polarisation ergibt. Günstigerweise sind die Mehrfachschichten 23 und 24 so ausgelegt, dass hinter dem zweiten Umlenkspiegel 16 im wesentlichen gleiche Amplituden von s- und p-Polarisation vorliegen. Mit diesem Licht ist eine Abbildung ohne strukturrichtungsabhängige Kontrastunterschiede möglich.

Das Reflexschichtsystem 24 des zweiten Umlenkspiegels 19 zeichnet sich unter anderem dadurch aus, dass auf der leicht absorbierenden Metallschicht 30 eine dielektrische Schicht 31 aufgebracht ist, deren Schichtdicke gezielt zur Erreichung von $R_p > R_s$ optimiert wurde. Im folgenden wird angegeben, wie für eine gegebene Materialkombination eine derartige Schichtdickenoptimierung allgemein möglich ist. Der von der Schichtdicke $d_f$ und vom Inzidenzwinkel $\alpha_o$ abhängige Reflexionsgrad $R_s$ für s-polarisiertes Licht ergibt sich aus dem Reflexionskoeffizient $r_s$ für dieses Licht gemäß folgender Gleichung:

$$R_s(\alpha_0, d_f) = r_s(\alpha_0, d_f) \cdot \overline{r_s(\alpha_0, d_f)} \qquad (2),$$

wobei der Querstrich das komplex Konjugierte des Wertes bezeichnet. Der entsprechende Reflexionskoeffizient für die s-Komponente berechnet sich wie folgt: Gleichung (3)

$$r_s(\alpha_0, d_f) =$$

$$\frac{N_{fs}(\alpha_0) \cdot [n_{0s}(\alpha_0) - N_{As}(\alpha_0)] \cdot \cos(\phi_f(\alpha_0, d_f)) + i \cdot [n_{0s}(\alpha_0) \cdot N_{As}(\alpha_0) - (N_{fs}(\alpha_0))^2] \cdot \sin(\phi_f(\alpha_0, d_f))}{N_{fs}(\alpha_0) \cdot [n_{0s}(\alpha_0) + N_{As}(\alpha_0)] \cdot \cos(\phi_f(\alpha_0, d_f)) + i \cdot [n_{0s}(\alpha_0) \cdot N_{As}(\alpha_0) + (N_{fs}(\alpha_0))^2] \cdot \sin(\phi_f(\alpha_0, d_f))}$$

Entsprechende Ausdrücke ergeben sich für den Reflexionsgrad $R_p$ und dem Reflexionskoeffizienten $r_p$ für die p-Komponente:

$$R_p(\alpha_0, d_f) = r_p(\alpha_0, d_f) \cdot \overline{r_p(\alpha_0, d_f)} \qquad (4)$$

und Gleichung (5):

$$r_p(\alpha_0, d_f) = \frac{N_{fp}(\alpha_0) \cdot [n_{0p}(\alpha_0) - N_{Ap}(\alpha_0)] \cdot \cos(\phi_f(\alpha_0, d_f)) + i \cdot [n_{0p}(\alpha_0) \cdot N_{Ap}(\alpha_0) - (N_{fp}(\alpha_0))^2] \cdot \sin(\phi_f(\alpha_0, d_f))}{N_{fp}(\alpha_0) \cdot [n_{0p}(\alpha_0) + N_{Ap}(\alpha_0)] \cdot \cos(\phi_f(\alpha_0, d_f)) + i \cdot [n_{0p}(\alpha_0) \cdot N_{Ap}(\alpha_0) + (N_{fp}(\alpha_0))^2] \cdot \sin(\phi_f(\alpha_0, d_f))}$$

In den Gleichungen repräsentieren die Werte $N_{fp}$ bzw. $N_{fs}$ die effektiven Brechzahlen der dielektrischen Schicht für p- bzw. s-Polarisation, die Terme $n_{0p}$ bzw. $n_{0s}$ die effektiven Brechzahlen des Umgebungsmediums, die Terme $N_{Ap}$ bzw. $N_{As}$ die effektiven Brechzahlen der Metallschicht und der Ausdruck $\Phi_f (d_f, \alpha_o)$ die Phasendicke der dielektrischen Schicht. Dabei gilt für die Phasendicke:

$$\phi_f(d_f, \alpha_0) = 2 \cdot \frac{\pi}{\lambda_0} \cdot d_f \cdot N_f \cdot \sqrt{1 - n_o^2 \cdot \frac{\sin^2(\alpha_0)}{N_f^2}} \qquad (6).$$

Die effektiven Brechzahlen $N_s$ bzw. $N_p$ für s- bzw. p-Polarisation berechnen sich allgemein gemäß:

$$N_s(\alpha_0) = \sqrt{N^2 - n_o^2 \cdot \sin^2(\alpha_0)} \qquad (7)$$

und

$$N_p(\alpha_0) = \frac{N^2}{N_s(\alpha_0)} \qquad (8),$$

wobei die Werte N jeweils die komplexe Brechzahl eines Mediums gemäß N = n - ik angeben. Dabei ist n der Realteil und k der Imaginärteil der komplexen Brechzahl des jeweiligen Mediums. In den Formeln stehen die Indizes A für das Substratmaterial (im Beispiel Aluminium) und f für die dielektrische Schicht.

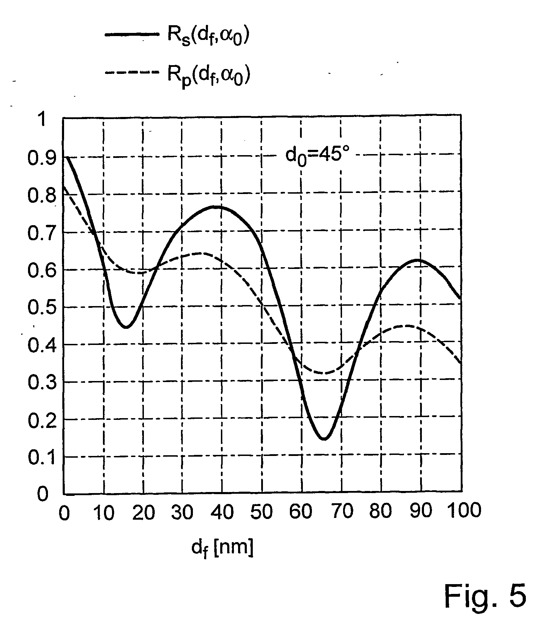

Setzt man nun für das Beispielssystem die optischen Konstanten der Siliziumdioxidschicht auf $n_f$ = 1,685 und $k_f$ = 0,055 sowie des Aluminium-Substrats auf $n_A$ = 0,143 und $k_A$ = 1,73, so ergibt sich für die Reflexionsgrade $R_s$ und Rp für einen Inzidenzwinkel von 45° die in Fig. 5 gezeigte Schichtdickenabhängigkeit. Es zeigt sich, dass die Reflexionsgrade $R_s$ und $R_p$ mit wachsender Schichtdicke $d_f$ jeweils annähernd periodisch variieren, wobei die Variationsamplitude bei $R_s$ größer ist als bei Rp. Die Kurven überschneiden sich mehrfach, so dass sich mehrere Schichtdickenbereiche ergeben, in denen $R_p$ größer als $R_s$ ist. Ein erster solcher bereich liegt zwischen ca. 10nm und ca. 25nm Schichtdicke, wobei der Bereich des maximalen Unterschiedes etwa bei 15nm liegt. Ein zweiter Bereich liegt zwischen ca. 60 und 75nm, wobei der größte Unterschied bei ca. 67nm liegt. Weiterhin ist erkennbar, dass die Absolutwerte der Reflexionsgrade mit steigender Schichtdicke tendenziell abnehmen. Dies ist im wesentlichen auf die geringfügige Absorption des dielektrischen Schichtmaterials Siliziumdioxid bei der gewählten Wellenlänge (157nm) zurückzuführen. Die Berechnung zeigt, das bei einer Schichtdicke von ca. 15nm eine Reflexionsschicht erhältlich ist, bei der der Reflexionsgrad $R_p$ für p-Polarisation um ca. 10% (bei ca. 45°) bis ca. 30% (bei ca. 60°) größer ist als der Reflexionsgrad $R_s$ für s-Polarisation. Hier ist $R_{sp}$ < 0,8.

Betrachtet man für das durchgerechnete System die Abhängigkeit der Reflexionsgrade $R_s$ und Rp vom Inzidenzwinkel, so ergibt sich die in Fig. 6 dargestellte Abhängigkeit. Es ist erkennbar, dass für ein System gegebener Schichtdicke $d_f$ der dielektrischen Schicht die Unterschiede zwischen der stärkeren Reflektivität der p-Polarisation und der schwächeren für s-Polarisation zunehmen, je größer der Inzidenzwinkel wird. Ein Vergleich der theoretischen Kurven in Fig. 6 mit den am tatsächlich gefertigten System ermittelten Reflexionsgraden in Fig. 4 zeigt eine qualitativ sehr gute Übereinstimmung, wobei auch die angegebenen Absolutwerte der Reflexionsgrade eine bemerkenswerte Übereinstimmung zeigen.

Bei einem bildlich nicht dargestellten Beispielssystem besteht die Reflexionsschicht aus einer optisch dichten Aluminiumschicht, auf der eine Einzelschicht aus Magnesiumfluorid aufgebracht ist, welches bei einer Wellenlänge von 157nm praktisch absorptionsfrei ist ($k_f$ = 0) und einen realen Brechungsindex $n_f$ = 1,48 hat. Die optischen Konstanten der Metallschicht werden mit $n_A$ = 0,072 und $k_A$ = 1,66 angenommen. Die optischen Konstanten der Metallschicht sind generell abhängig vom Beschichtungsverfahren und können z.B. auch die obigen, im Zusammenhang mit der SiO$_2$-Schicht genannten Werte annehmen.

Bei dieser Reflexionsschicht ist bei einem Inzidenzwinkel von 45° im Dickenbereich von ca. 15nm bis ca. 24nm die Bedingung $R_s$ < Rp erfüllt. Geht man zu höheren Einfallswinkeln, so verbreitet sich dieser Bereich. So ist beispielsweise bei 60° Inzidenzwinkel die Bedingung $R_s \leq R_p$ im Dickenbereich von ca. 13nm bis ca. 33nm erfüllt. Daraus ergibt sich, dass für den wichtigen Inzidenzwinkelbereich um ca. 45°, beispielsweise zwischen 40° und 50°, besonders günstige Schichtdicken im Bereich zwischen ca. 15nm und ca. 30nm liegen. Analog zu Fig. 5 sind auch Schichtdickenbereiche höherer Ordnungen möglich. Ein Nachteil von Schichtdickenbereichen höherer Ordnung besteht generell darin, dass die Bedingung $R_p$ > $R_s$ nur über einen vergleichsweise geringeren Einfallswinkelbereich erfüllt ist. Unter anderen aus diesem Grund sind geringe Schichtdicken aus den jeweils ersten Schichtdickenbereichen mit Rp > $R_s$ bevorzugt.

Die Erfindung wurde anhand konkreter Ausführungsbeispiele erläutert. Durch die Angabe der der Erfindung zugrundeliegenden Überlegungen und entsprechender Formeln ist eine Verallgemeinerung für den Fachmann auch auf viele andere, für eine jeweilige Arbeitswellenlänge geeignete Systeme möglich. Eine Überprüfung, ob eine gegebene Materialkombination aus Metallschicht und dielektrischer Schicht zur Erzielung von $R_p$ > $R_s$ geeignet ist, ist anhand der obigen Darstellungen ohne weiteres möglich.

**Patentansprüche**

1. Katadioptrisches Projektionsobjektiv zur Abbildung eines in der Objektebene des Projektionsobjektivs angeordneten Musters in die Bildebene des Projektionsobjektivs mit:

   einer optischen Achse;
   einem ersten Umlenkspiegel, der gegenüber der optischen Achse um einen ersten Kippwinkel gekippt ist; und
   einem zweiten Umlenkspiegel, der gegenüber der optischen Achse um einen zweiten Kippwinkel gekippt ist;

wobei zwischen der Objektebene und der Bildebene ein katadioptrischer Objektivteil mit einem Konkavspiegel und dem ersten Umlenkspiegel angeordnet ist, der zur Umlenkung der von der Objektebene kommenden Strahlung zum Konkavspiegel oder zur Umlenkung der vom Konkavspiegel kommenden Strahlung zur Bildebene vorgesehen ist, und der zweite Umlenkspiegel derart senkrecht zum ersten Umlenkspiegel ausgerichtet ist, dass die Objektebene und die Bildebene parallel zueinander ausgerichtet sind;
wobei ein Verhältnis $R_{sp}$ zwischen dem Reflexionsgrad $R_s$ eines Umlenkspiegels für s-polarisiertes Licht und dem Reflexionsgrad $R_p$ des Umlenkspiegels für p-polarisiertes Licht aus einem den zugeordneten Kippwinkel umfassenden Inzidenzwinkelbereich bei einem der Umlenkspiegel größer als eins und bei dem anderen Umlenkspiegel kleiner als eins ist, so dass eine durch den ersten Umlenkspiegel verursachte Veränderung im Verhältnis der reflektierten Intensitäten für s- und p-Polarisation mit Hilfe der Reflexion am zweiten Umlenkspiegel zumindest teilweise kompensiert wird,
wobei derjenige Umlenkspiegel, bei dem das Verhältnis $R_{sp}$ in einem den Kippwinkel des Umlenkspiegels umfassenden Inzidenzwinkelbereich kleiner als eins ist, eine Reflexbeschichtung aufweist, die eine Metallschicht und eine auf der Metallschicht angeordnete dielektrische Schicht aus dielektrischem Material umfasst, wobei eine Schichtdicke $d_f$ der dielektrischen Schicht so gewählt ist, dass das Verhältnis $R_{sp}$ in einem den Kippwinkel des Umlenkspiegels umfassenden inzidenzwinkelbereich kleiner als eins ist.

2. Projektionsobjektiv nach Anspruch 1, bei dem der erste Kippwinkel und der zweite Kippwinkel im Bereich 45° $\pm$ 15°, insbesondere im Bereich 45° $\pm$ 10° liegen.

3. Projektionsobjektiv nach Anspruch 1 oder 2, bei dem für einen der Umlenkspiegel bei einem dem zugeordneten Kippwinkel entsprechenden Inzidenzwinkel das Verhältnis $R_{sp}$ kleiner als 0,9, insbesondere kleiner als 0,8 ist.

4. Projektionsobjektiv nach einem der vorhergehenden Ansprüche, bei dem die Metallschicht im wesentlichen aus Aluminium besteht.

5. Projektionsobjektiv nach nach einem der vorhergehenden Ansprüche, bei dem die dielektrische Schicht eine Einfachschicht ist.

6. Projektionsobjektiv nach einem der vorhergehenden Ansprüche, bei dem das dielektrische Material bei der Arbeitswellenlänge des Projektionsobjektivs im wesentlichen absorptionsfrei ist oder bei dem das dielektrische Material bei der Arbeitswellenlänge des Projektionsobjektivs leicht absorbierend ist, wobei ein Absorptionskoeffizient k des dielektrischen Materials bei der Arbeitswellenlänge vorzugsweise weniger als 0,6, insbesondere weniger als 0,01 beträgt.

7. Projektionsobjektiv nach einem der vorhergehenden Ansprüche, bei dem die dielektrische Schicht im wesentlichen aus einem der folgenden Materialien oder aus einer Kombination dieser Materialien besteht: Magnesiumfluorid ($MgF_2$), Aluminiumfluorid ($AlF_3$), Chiolith, Kryolith, Gadoliniumfluorid ($GdF_3$), Siliziumdioxid ($SiO_2$), Hafniumoxid ($H_fO_2$), Aluminiumoxid ($Al_2O_3$), Lanthanfluorid ($LaF_3$) oder Erbiumfluorid ($ErF_3$)

8. Projektionsobjektiv nach einem der vorhergehenden Ansprüche, bei dem die Schichtdicke $d_f$ der dielektrischen Schicht so gewählt ist, dass folgende Bedingung erfüllt ist:

$$0.3 \le \frac{\sin\left(\phi_f\left(d_f, \alpha_0\right)\right)}{N_f \cdot \cos\left(\phi_f\left(d_f, \alpha_0\right)\right)} \le 1.5 \,,$$

wobei $\Phi_f$ die Phasendicke der dielektrischen Schicht als Funktion der Schichtdicke $d_f$ und des Inzidenzwinkels $\alpha_0$ und $N_f$ die komplexe Brechzahl des dielektrischen Materials ist.

9. Projektionsobjektiv nach einem der vorhergehenden Ansprüche, das für Ultraviolettlicht mit einer Wellenlänge von weniger als 260nm ausgelegt ist, insbesondere für 157nm, 193nm oder 248nm Arbeitswellenlänge.

**Claims**

1. Catadioptric projection objective for projecting a pattern arranged in the object plane of the projection objective into the image plane of the projection objective, having:

an optical axis;
a first deviating mirror, which is tilted relative to the optical axis by a first tilt angle; and
a second deviating mirror, which is tilted relative to the optical axis by a second tilt angle;
wherein a catadioptric objective part having a concave mirror and the first deviating mirror, which is intended to deviate the radiation coming from the object plane toward the concave mirror or to deviate the radiation coming from the concave mirror toward the image plane, is arranged between the object plane and the image plane, and the second deviating mirror is oriented perpendicularly to the first deviating mirror, so that the object plane and the image plane are aligned parallel with each other;
wherein a ratio $R_{sp}$ between the reflectivity $R_s$ of a deviating mirror for s-polarized light and the reflectivity $R_p$ of the deviating mirror for p-polarized light is greater than one for one of the deviating mirrors and less than one for the other deviating mirror in an angle of incidence range comprising the assigned tilt angle, so that a change in the ratio of the reflected intensities for s- and p-polarization, caused by the first deviating mirror, is at least partially compensated for with the aid of the reflection at the second deviating mirror, wherein that deviating mirror in which the ratio $R_{sp}$ is less than one in an angle of incidence range comprising the tilt angle of the deviating mirror has a reflective coating, which comprises a metal layer and a dielectric layer of dielectric material arranged on the metal layer, a layer thickness $d_f$ of the dielectric layer being selected so that the ratio $R_{sp}$ is less than one in an angle of incidence range comprising the tilt angle of the deviating mirror.

2. Projection objective according to Claim 1, wherein the first tilt angle and the second tilt angle lie in the range of 45° ± 15°, in particular in the range of 45° ± 10°.

3. Projection objective according to Claim 1 or 2, wherein the ratio $R_{sp}$ is less than 0.9, in particular less than 0.8 for one of the deviating mirrors at an angle of incidence corresponding to the assigned tilt angle.

4. Projection objective according to one of the preceding claims, wherein the metal layer essentially consists of aluminum.

5. Projection objective according to one of the preceding claims, wherein the dielectric layer is a single layer.

6. Projection objective according to one of the preceding claims, wherein the dielectric material is essentially absorption-free at the working wavelength of the projection objective, or wherein the dielectric material is slightly absorbent at the working wavelength of the projection objective, an absorption coefficient k of the dielectric material being preferably less than 0.6, in particular less than 0.01 at the working wavelength.

7. Projection objective according to one of the preceding claims, wherein the dielectric layer essentially consists of one of the following materials or a combination of these materials: magnesium fluoride ($MgF_2$), aluminum fluoride ($AlF_3$), chiolite, cryolite, gadolinium fluoride ($GdF_3$), silicon dioxide ($SiO_2$), hafnium oxide ($H_fO_2$), aluminum oxide ($Al_2O_3$), lanthanum fluoride ($LaF_3$) or erbium fluoride ($ErF_3$).

8. Projection objective according to one of the preceding claims, wherein the layer thickness $d_f$ of the dielectric layer is selected so that the following condition is satisfied:

$$0.3 \le \frac{\sin(\phi_f(d_f, \alpha_0))}{N_f \cdot \cos(\phi_f(d_f, \alpha_0))} \le 1.5 \;,$$

where $\Phi_f$ is the phase thickness of the dielectric layer as a function of the layer thickness $d_f$ and of the angle of incidence $\alpha_o$, and $N_f$ is the complex refractive index of the dielectric material.

9. Projection objective according to one of the preceding claims, which is designed for ultraviolet light having a wavelength of less than 260 nm, in particular for a working wavelength of 157 nm, 193 nm or 248 nm.

**Revendications**

1. Objectif de projection catadioptrique pour la représentation dans le plan image de l'objectif de projection, d'un motif disposé dans le plan objet de l'objectif de projection, avec :

   un axe optique ;
   un premier miroir de déviation basculé d'un premier angle de basculement par rapport à l'axe optique ; et
   un deuxième miroir de déviation basculé d'un deuxième angle de basculement par rapport à l'axe optique ;
   un élément d'objectif catadioptrique avec un miroir concave et le premier miroir de déviation étant disposé entre le plan objet et le plan image, celui-ci étant prévu pour la déviation du rayonnement provenant du plan objet en direction du miroir concave ou pour la déviation du rayonnement provenant du miroir concave en direction du plan image et le deuxième miroir de déviation étant orienté perpendiculairement au premier miroir de déviation de telle sorte que le plan objet et le plan image soient orientés parallèlement l'un par rapport à l'autre ;
   un rapport $R_{sp}$ entre le degré de réflexion $R_s$ d'un miroir de déviation pour la lumière polarisée selon s et le degré de réflexion $R_p$ du miroir de déviation pour la lumière polarisée selon p étant, dans une plage angulaire d'indices englobant l'angle de basculement, supérieur à un pour un des miroirs de déviation et inférieur à un pour l'autre miroir de déviation, de telle sorte qu'une modification engendrée par le premier miroir de déviation soit au moins partiellement compensée en proportion des intensités réfléchies pour la polarisation s et p à l'aide de la réflexion sur le deuxième miroir de déviation,
   le miroir de déviation, pour lequel le rapport $R_{sp}$ pour une plage angulaire d'indices englobant l'angle de basculement du miroir de déviation est inférieur à un, présentant un revêtement réfléchissant comportant une couche métallique et une couche diélectrique de matériau diélectrique disposée sur la couche métallique, une épaisseur de couche $d_f$ de la couche diélectrique étant choisie de telle sorte que le rapport $R_{sp}$ pour une plage angulaire d'indices englobant l'angle de basculement du miroir de déviation est inférieur à un.

2. Objectif de projection selon la revendication 1, dans lequel le premier angle de basculement et le deuxième angle de basculement se situent dans la plage de $45° \pm 15°$, notamment dans la plage de $45° \pm 10°$.

3. Objectif de projection selon la revendication 1 ou 2, dans lequel le rapport $R_{sp}$ pour une plage angulaire d'indices englobant l'angle de basculement du miroir de déviation, est inférieur à 0,9, notamment inférieur à 0,8.

4. Objectif de projection selon une des revendications précédentes, dans lequel la couche métallique est pour l'essentiel constituée d'aluminium.

5. Objectif de projection selon une des revendications précédentes, dans lequel la couche diélectrique est une couche unique.

6. Objectif de projection selon une des revendications précédentes, dans lequel le matériau diélectrique ne présente pour l'essentiel pas d'absorption à la longueur d'ondes de fonctionnement de l'objectif de projection ou dans lequel le matériau diélectrique est légèrement absorbant à la longueur d'ondes de fonctionnement de l'objectif de projection, le coefficient d'absorption k du matériau diélectrique valant de préférence moins de 0,6, notamment moins de 0,01.

7. Objectif de projection selon une des revendications précédentes, dans lequel la couche diélectrique est pour l'essentiel constituée d'un des matériaux suivants ou d'une combinaison de ces matériaux : fluorure de magnésium ($MgF_2$), fluorure d'aluminium ($AlF_3$), chiolithe, cryolithe, fluorure de gadolinium ($GdF_3$), dioxyde de silicium ($SiO_2$), oxyde d'hafnium ($HfO_2$), oxyde d'aluminium ($Al_2O_3$), fluorure de lanthane ($LaF_3$) ou fluorure d'erbium ($ErF_3$).

8. Objectif de projection selon une des revendications précédentes, dans lequel l'épaisseur de couche $d_f$ de la couche diélectrique est choisie de manière à satisfaire la condition suivante :

$$0.3 \leq \frac{\sin(\phi_f(d_f, \alpha_0))}{N_f \cdot \cos(\phi_f(d_f, \alpha_0))} \leq 1.5$$

   dans laquelle $\Phi_f$ est l'épaisseur de phase de la couche diélectrique en fonction de l'épaisseur de couche $d_f$ et de l'angle d'incidence $\alpha_0$ et $N_f$ est l'indice de réfraction complexe du matériau diélectrique.

**9.** Objectif de projection selon une des revendications précédentes, conçu pour la lumière ultraviolette dont la longueur d'ondes est inférieure à 260 nm, notamment pour les longueurs d'ondes de fonctionnement de 157 nm, 193 nm ou 248 nm.

Fig. 1

Fig. 2

Fig. 3

Fig. 4

Fig. 6

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 964282 A2
- DE 19851749
- EP 1001295 A
- US 4322130 A
- US 4856019 A
- US 4714308 A
- US 5850309 A